# EUROPEAN PATENT APPLICATION

(11) **EP 4 618 141 A1**
(43) Date of publication of application: **17.09.2025**
(21) Application number: 23888068.6
(22) Date of filing: 09.11.2023
(51) Int. Cl.: H01L 21/687

(54) **SEMICONDUCTOR PROCESS CHAMBER AND CARRYING DEVICE THEREOF**

(30) Priority: 10.11.2022 CN 202211405433
(71) Applicant: Beijing NAURA Microelectronics Equipment Co., Ltd., Beijing 100176 (CN)
(72) Inventor: LI, Junheng, Beijing 100176 (CN); JI, Kehong, Beijing 100176 (CN); LI, Dongdong, Beijing 100176 (CN)
(74) Representative: Cohausz & Florack
(86) International application number: PCT/CN2023/130617
(87) International publication number: WO 2024/099383

(57) **Abstract**

The present disclosure provides a semiconductor process chamber and a carrying device thereof. The carrying device includes a carrying plate and a plurality of support members, the carrying plate is provided with a plurality of avoidance holes which are in one-to-one correspondence with positions of the plurality of support members and penetrate through the carrying plate along a height direction, the carrying plate is capable of moving up and down relative to the support members, so as to enable top ends of the support members to pass out through the avoidance holes to be above the carrying plate and hold a wafer up from the carrying plate or to enable the top ends of the support members to retract into the avoidance holes and place the wafer on the carrying plate, the carrying device further includes a plurality of matching sleeves, which are disposed in the plurality of avoidance holes in a one-to-one correspondence manner, outer surfaces of the matching sleeves are attached to outer walls of the avoidance holes, and the support members are capable of passing through the matching sleeves at corresponding positions. **In** the present disclosure, particles can be attached to the matching sleeves after entering the avoidance holes, and only the matching sleeves need to be detached and separately cleaned when cleaning is needed, which simplifies maintenance operations for the carrying device and the semiconductor process chamber. The present disclosure further provides a semiconductor process chamber.

## Description

### TECHNICAL FIELD

The present disclosure relates to the field of semiconductor process devices, and in particular, to a carrying device and a semiconductor process chamber including the same.

### BACKGROUND

The Physical Vapor Deposition (PVD) process refers to a semiconductor processing process for depositing a metal film on a wafer with a physical method. In the field of semiconductor processing technology, the wafer is generally carried by a base or wafer support rods. When a metal film is already deposited on a back surface of the wafer except for an edge region of the back surface and a front surface of the wafer needs to be subjected to metal film deposition, in order to avoid damaging the metal film on the back surface of the wafer, the wafer can be supported only by contact with an edge of the wafer.

In an existing semiconductor process chamber, the wafer is generally picked up or placed through cooperation between pins and a carrying plate, that is, the pins can pass out through pin holes in the carrying plate to be above a carrying surface of the carrying plate; when the wafer is transferred into the semiconductor process chamber, a manipulator places the wafer on tops of a plurality of pins which pass out, and then the carrying plate is raised to enable the pins retract to be under the carrying surface of the carrying plate, so that the carrying plate can carry the wafer for a corresponding process; and after the process is ended, the carrying plate is lowered to enable the pins to pass out again and push the wafer up, so as to allow the manipulator to pick the wafer up.

However, the cleanliness of the carrying plate in the existing semiconductor process chamber often deteriorates gradually as the process proceeds, so that the carrying plate needs to be periodically disassembled and maintained for preventing contaminants and particles on the carrying plate from affecting a semiconductor process effect. The carrying plate has many parts and it takes a long time to disassemble and assemble the carrying plate, which significantly affects machine production capacity. Therefore, how to improve maintenance efficiency of the carrying plate and ensure the machine production capacity becomes an urgent technical problem to be solved in the field.

### SUMMARY

The present disclosure aims to provide a carrying device capable of improving both maintenance efficiency of a carrying plate and machine production capacity, and a semiconductor process chamber.

**In** order to achieve the above objectives, in one aspect of the present disclosure, there is provided a carrying device for being disposed in a chamber body of a semiconductor process chamber, the carrying device includes a carrying plate and a plurality of support members, the carrying plate is provided with a plurality of avoidance holes which are in one-to-one correspondence with positions of the plurality of support members and penetrate through the carrying plate along a height direction, the carrying plate is capable of moving up and down relative to the support members, so as to enable top ends of the support members to pass out through the avoidance holes to be above the carrying plate and hold a wafer up from the carrying plate or to enable the top ends of the support members to retract into the avoidance holes and place the wafer on the carrying plate, the carrying device further includes a plurality of matching sleeves, which are disposed in the plurality of avoidance holes in a one-to-one correspondence manner, outer surfaces of the matching sleeves are attached to outer walls of the avoidance holes, and the support members are capable of passing through the matching sleeves at corresponding positions.

Optionally, the carrying device further includes a lifting assembly, which is configured to drive the carrying plate to move up and down, the carrying plate includes a radio frequency feed plate and an insulating assembly, the insulating assembly is connected between the lifting assembly and the radio frequency feed plate, and has a supporting surface for supporting the wafer, and the supporting surface is higher than a top surface of the radio frequency feed plate, and is configured to support the wafer carried on the support members when the top ends of the plurality of support members are lowered below the supporting surface.

Optionally, the avoidance holes include insulating avoidance structures formed in the insulating assembly, the matching sleeves include insulating sleeve members disposed in the insulating avoidance structures, the insulating sleeve members are provided with first sleeve holes, and the support members are capable of passing through the first sleeve holes in the insulating sleeve members along a vertical direction.

Optionally, the insulating assembly includes an insulating plate, a middle insulating ring, and a top insulating ring, a bottom of the insulating plate is connected to the lifting assembly, a bottom of the middle insulating ring is disposed on the insulating plate, the radio frequency feed plate is disposed above the middle insulating ring, the top insulating ring is disposed around the radio frequency feed plate and at a top of the middle insulating ring, and the top insulating ring is provided with the supporting surface; and
the insulating avoidance structures include a plurality of first avoidance notches which are formed on an inner circumferential wall of the top insulating ring and in one-to-one correspondence with the positions of the plurality of support members, and a plurality of second avoidance notches formed in the middle insulating ring, and a plurality of insulating sleeve members are disposed in the plurality of second avoidance notches in a one-to-one correspondence manner.

Optionally, the carrying plate further includes a shielding assembly, and the chamber body includes a loading chamber body and a process chamber body located at a top of the loading chamber body and communicated with the loading chamber body, a shielding cylinder is disposed on an inner side of a sidewall of the process chamber body, and the lifting assembly is capable of driving the carrying plate to raise to a position where the shielding assembly is in contact with a bottom end of the shielding cylinder, so as to isolate a process cavity inside the process chamber body from a loading cavity inside the loading chamber body with the shielding cylinder, the shielding assembly, and the carrying plate and electrically connect the shielding cylinder to the shielding assembly.

Optionally, the avoidance holes further include shielding avoidance structures formed in the shielding assembly, the matching sleeves further include conductive sleeve members disposed in the shielding avoidance structures, the conductive sleeve members support the insulating sleeve members in a one-to-one correspondence manner, the conductive sleeve members are provided with second sleeve holes, and the support members are capable of passing through the second sleeve holes along the vertical direction.

Optionally, hole walls of the first sleeve holes and hole walls of the second sleeve holes are surface-treated surfaces, roughness of the hole walls of the first sleeve holes is greater than roughness of other surfaces of the insulating sleeve members, and roughness of the hole walls of the second sleeve holes is greater than roughness of other surfaces of the conductive sleeve members.

Optionally, one of a top of each conductive sleeve member and a bottom of each insulating sleeve member is provided with at least one positioning protrusion, the other of the top of each conductive sleeve member and the bottom of each insulating sleeve member is provided with at least one positioning groove, and positioning protrusions are accommodated in corresponding positioning grooves in a one-to-one correspondence manner.

Optionally, the shielding assembly includes a support connection plate, a ground shielding ring, and a top shielding member, the support connection plate is disposed under a bottom of the insulating assembly and is grounded through the lifting assembly, the ground shielding ring is disposed around an outer side of the insulating assembly, and the top shielding member is disposed around the outer side of the insulating assembly and on a top surface of the ground shielding ring; the shielding avoidance structures are formed in the ground shielding ring; and
the lifting assembly is capable of driving the carrying plate to raise to a position where the top shielding member is in contact with the bottom end of the shielding cylinder, so as to isolate the process cavity inside the process chamber body from the loading cavity inside the loading chamber body with the shielding cylinder, the top shielding member, and the carrying plate and electrically connect the shielding cylinder to the support connection plate through the top shielding member.

Optionally, the conductive sleeve members include conductive main bodies and conductive extensions, the second sleeve holes are formed in the conductive main bodies, and the conductive extensions are located on outer sides of the conductive main bodies along a radial direction; and the shielding avoidance structures include sleeve positioning grooves formed on the top surface of the ground shielding ring, and sleeve positioning holes penetrating from bottoms of the sleeve positioning grooves to a bottom of the ground shielding ring, the sleeve positioning grooves extend along a radial direction of the ground shielding ring to be connected to an inner circumferential side of the ground shielding ring, the conductive main bodies are disposed in the sleeve positioning holes, and the conductive extensions are fixedly disposed in the sleeve positioning grooves.

Optionally, the carrying device further includes a plurality of first positioning pins and a plurality of first fixing screws, the bottoms of the sleeve positioning grooves are provided with a plurality of first pin holes and a plurality of first threaded holes which penetrate to the bottom of the ground shielding ring, the conductive extensions are provided with a plurality of first positioning holes and a plurality of first mounting holes which penetrate through the conductive extensions along an axial direction of the carrying plate, the plurality of first positioning pins pass through the plurality of first positioning holes and the corresponding first pin holes in a one-to-one correspondence manner, and the plurality of first fixing screws pass through the plurality of first mounting holes and the corresponding first threaded holes in a one-to-one correspondence manner, so as to fixedly connect the ground shielding ring to a plurality of conductive extensions.

Optionally, an annular supporting groove connected to an inner hole of the top insulating ring is formed on a top surface of the top insulating ring, a bottom surface of the annular supporting groove is formed into the supporting surface, and a sidewall of the annular supporting groove is configured to limit the wafer placed on the supporting surface.

Optionally, the carrying device further includes a connecting ring, which is disposed around an axis of the carrying plate and is configured to be fixedly connected to the chamber body; and
the support members include columnar portions and connecting portions, the connecting portions are fixedly connected to the connecting ring, the columnar portions extend along a vertical direction, top ends of the columnar portions are configured to pass through the corresponding avoidance holes and support the wafer, the connecting portions extend along a radial direction of the carrying plate, and ends of the connecting portions facing an axis of the carrying plate are fixedly connected to bottom ends of the columnar portions.

Optionally, an accommodating groove is formed on an end surface of a top end of each columnar portion, one side of the accommodating groove facing the axis of the carrying plate extends to a side surface of the columnar portion, a bottom surface of the accommodating groove is configured to support the wafer, and a sidewall of the accommodating groove is configured to limit an edge of the wafer.

Optionally, shapes of orthographic projections of the columnar portions on a horizontal plane are squares, and shapes of orthographic projections of inner holes of the matching sleeves correspond to the shapes of the orthographic projections of the columnar portions on the horizontal plane.

Optionally, the carrying device further includes a plurality of second positioning pins and a plurality of second fixing screws, and
a plurality of supporting positioning grooves are formed at a top of the connecting ring, the connecting portions are disposed in the supporting positioning grooves in a one-to-one correspondence manner, bottoms of the supporting positioning grooves are provided with second pin holes and second threaded holes which penetrate to a bottom of the connecting ring, the connecting portions are provided with second positioning holes and second mounting holes which penetrate through the connecting portions along an axial direction of the carrying plate, the plurality of second positioning pins pass through a plurality of second positioning holes and the corresponding second pin holes in a one-to-one correspondence manner, and the plurality of second fixing screws pass through a plurality of second mounting holes and the corresponding second threaded holes in a one-to-one correspondence manner, so as to fixedly connect the connecting ring to a plurality of connecting portions.

**In** a second aspect of the present disclosure, there is provided a semiconductor process chamber, including a chamber body and the aforesaid carrying device.

**In** the carrying device and the semiconductor process chamber provided in the present disclosure, the matching sleeves are disposed in the avoidance holes of the carrying plate, and the support members pass through the matching sleeves to extend out of the avoidance holes or retract into the avoidance holes, so that particles falling from above the carrying plate can be attached to the matching sleeves after entering the avoidance holes when a semiconductor process is performed. When the particles attached to the avoidance holes are too many and cleaning is needed for restoring cleanliness of the carrying plate, instead of detaching all parts of the carrying plate one by one, only the matching sleeves need to be detached and separately cleaned, which simplifies an maintenance operation for the semiconductor process chamber, and shortens the time spent on disassembling and assembling the carrying plate in the maintenance operation, thereby improving the maintenance efficiency of the carrying plate and ensuring the machine production capacity.

### BRIEF DESCRIPTION OF DRAWINGS

The accompany drawings are intended to provide a further understanding of the present disclosure and constitute a part of the specification. Together with the following specific implementations, the drawings are used to explain the present disclosure, but do not constitute any limitation to the present disclosure. In the drawings:
FIG. 1(a) is a schematic structural diagram of a semiconductor process chamber in an existing art;
FIG. 1(b) is a schematic diagram of the semiconductor process chamber shown in FIG. 1(a) in another state;
FIG. 2 is a schematic structural diagram of a wafer support assembly shown in FIG. 1(a);
FIG. 3 is a schematic structural diagram of a semiconductor process chamber according to an embodiment of the present disclosure;
FIG. 4 is a partial enlarged view of the semiconductor process chamber shown in FIG. 3;
FIG. 5 is a top view of a top insulating ring in a semiconductor process chamber according to an embodiment of the present disclosure;
FIG. 6 is a partial enlarged view of the semiconductor process chamber shown in FIG. 3;
FIG. 7 is a top view illustrating a connection relationship between a ground shielding ring and conductive sleeve members in a semiconductor process chamber according to an embodiment of the present disclosure;
FIG. 8 is a sectional view illustrating a connection relationship between a ground shielding ring and conductive sleeve members in a semiconductor process chamber according to an embodiment of the present disclosure;
FIG. 9 is a top view of a semiconductor process chamber according to an embodiment of the present disclosure;
FIG. 10 is a schematic structural diagram of a connecting ring in a semiconductor process chamber according to an embodiment of the present disclosure;
FIG. 11 is a sectional view of the connecting ring shown in FIG. 10;
FIG. 12 is a schematic structural diagram of a support member in a semiconductor process chamber according to an embodiment of the present disclosure;
FIG. 13 is a top view of the support member shown in FIG. 12;
FIG. 14 is a schematic structural diagram of an insulating sleeve member in a semiconductor process chamber according to an embodiment of the present disclosure; and
FIG. 15 is a top view of the insulating sleeve member shown in FIG. 14.

### DETAIL DESCRIPTION OF EMBODIMENTS

The specific implementations of the present disclosure are described in detail below with reference to the drawings. It should be understood that the specific implementations described herein are only intended to describe and explain the present disclosure, rather than limiting the present disclosure.

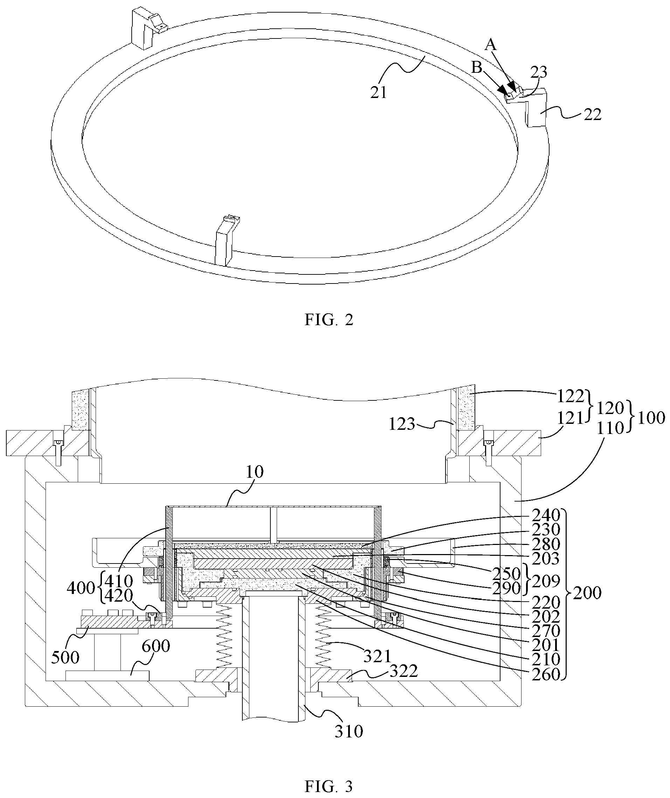

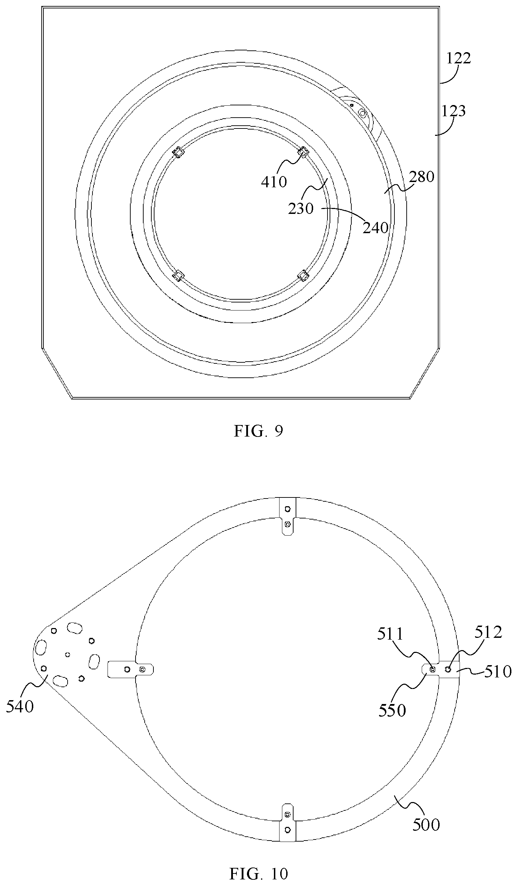

In order to at least solve the above technical problem, in one aspect of the present disclosure, there is provided a carrying device, which is disposed in a chamber body 100 of a semiconductor process chamber. As shown in FIG. 3 and FIG. 9, the carrying device includes a carrying plate 200 and a plurality of support members 400, the carrying plate 200 is provided with a plurality of avoidance holes which are in one-to-one correspondence with positions of the plurality of support members 400 and penetrate through the carrying plate 200 along a height direction, and the carrying plate 200 is capable of moving up and down relative to the support members 400, so as to enable top ends of the support members 400 to pass out through the avoidance holes to be above the carrying plate 200 and hold a wafer 10 up from the carrying plate 200 or to enable the top ends of the support members 400 to retract into the avoidance holes and place the wafer 10 on the carrying plate 200. The carrying device further includes a plurality of matching sleeves 209 which are disposed in the plurality of avoidance holes in a one-to-one correspondence manner, outer surfaces of the matching sleeves 209 are attached to outer walls of the avoidance holes, and the support members 400 are capable of passing through the matching sleeves 209 at corresponding positions.

**In** the carrying device provided in the present disclosure, the matching sleeves 209 are disposed in the avoidance holes of the carrying plate 200, and the support members 400 pass through the matching sleeves 209 to extend out of the avoidance holes or retract into the avoidance holes, so that particles falling from above the carrying plate 200 can be attached to the matching sleeves 209 after entering the avoidance holes when a semiconductor process is performed. When the particles attached to the avoidance holes are too many and cleaning is needed for restoring cleanliness of the carrying plate 200, instead of detaching all parts of the carrying plate 200 one by one, only the matching sleeves 209 need to be detached and separately cleaned, which simplifies maintenance operations for the carrying device and the semiconductor process chamber, and shortens the time spent on disassembling and assembling the carrying plate 200 in the maintenance operations, thereby improving the maintenance efficiency of the carrying plate and ensuring the machine production capacity.

**In** an alternative implementation of the present disclosure, the carrying device further includes a lifting assembly configured to drive the carrying plate 200 to move up and down.

**In** an alternative implementation of the present disclosure, as shown in FIG. 3, the lifting assembly may include a drive component (not shown) and a lifting shaft 310, an avoidance through hole is formed in a bottom wall of the chamber body 100, a bottom end of the lifting shaft 310 is connected to the drive component, and a top end of the lifting shaft 310 passes through the avoidance through hole to enter the chamber body 100, and is fixedly connected to a bottom of the carrying plate 200.

**In** order to ensure airtightness of the semiconductor process chamber, exemplarily, as shown in FIG. 3, the lifting assembly further includes a corrugated tube 321 sleeved over the lifting shaft 310, a top end of the corrugated tube 321 is hermetically connected to the bottom of the carrying plate 200, and a bottom end of the corrugated tube 321 is hermetically connected to the avoidance through hole, so as to isolate an interior of the chamber body 100 from the external space. Optionally, as shown in FIG. 3, the lifting assembly further includes a bottom flange 322 fixedly disposed at the bottom of the carrying plate 200 and configured to hermetically connect the bottom end of the corrugated tube 321 to the avoidance through hole.

Exemplarily, as shown in FIG. 3, the lifting shaft 310 is provided therein with a wire hole penetrating through the lifting shaft 310 along an axial direction of the lifting shaft 310, and cables and pipelines of external components may be connected to the carrying plate 200 through the wire hole, so as to supply electrical signals or cooling water to the carrying plate 200.

**In** an alternative implementation of the present disclosure, as shown in FIG. 3 to FIG. 6, the carrying plate 200 includes a radio frequency feed plate 240 and an insulating assembly, the insulating assembly is connected between the lifting assembly and the radio frequency feed plate 240, and has a supporting surface C for supporting the wafer 10, the supporting surface C is higher than a top surface of the radio frequency feed plate 240, and is configured to support the wafer 10 carried on the plurality of support members 400 when the top ends of the plurality of support members 400 are lowered below the supporting surface C. **In** the embodiment of the present disclosure, the supporting surface C of the insulating assembly is higher than the top surface of the radio frequency feed plate 240, so that the wafer can be supported by the supporting surface C instead of the top ends of the support members 400 when the carrying plate is raised higher than the top ends of the support members 400, and the radio frequency feed plate 240 can be always prevented from being in direct contact with a bottom surface of the wafer, which ensures integrity of a film on a back surface of the wafer 10, and improves yield of wafer products.

**In** an alternative implementation of the present disclosure, the avoidance holes include insulating avoidance structures formed in the insulating assembly, the matching sleeves 209 include insulating sleeve members 250 disposed in the insulating avoidance structures, the insulating sleeve members 250 are provided with first sleeve holes 251, and the support members 400 are capable of passing through the first sleeve holes 251 in the insulating sleeve members 250 along a vertical direction.

**In** the embodiment of the present disclosure, the avoidance holes include the insulating avoidance structures formed in the insulating assembly, and the insulating sleeve members 250 are disposed in the insulating avoidance structures, so that the insulating sleeve members 250 are used instead of inner walls of the avoidance holes to form gaps with the support members 400. When a semiconductor process is performed, the particles falling from above the carrying plate can be attached to inner walls of the first sleeve holes 251 of the insulating sleeve members 250. When cleaning is needed due to too many particles, only the insulating sleeve members 250 need to be detached and separately cleaned, and the structures such as the insulating assembly do not need to be detached from the carrying plate 200, so that the maintenance operations for the carrying device and the semiconductor process chamber are simplified.

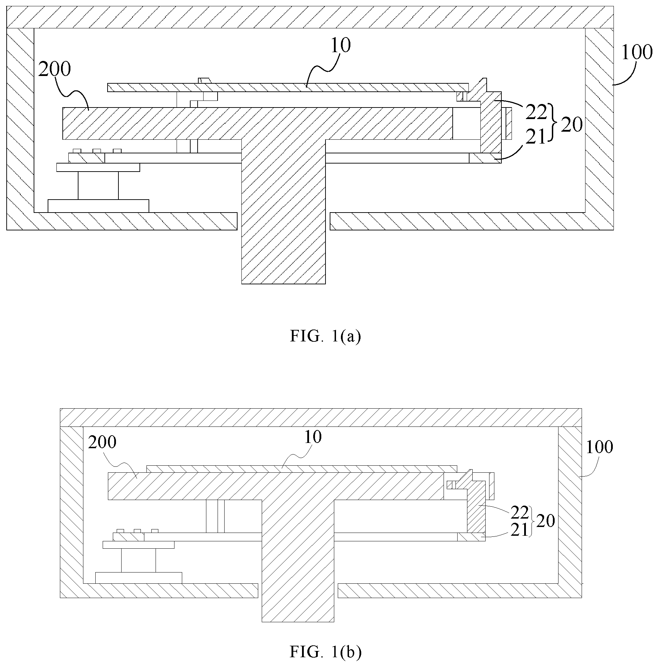

It has been found in the research that, in existing solutions, for example, when the carrying plate 200 is raised to a certain position (when a top surface of the carrying plate 200 is higher than supporting surfaces B of support rods 22) as shown in FIG. 1(b), the wafer 10 is supported by the top surface of the carrying plate 200 instead of the supporting surfaces B of the support rods 22, in which case the top surface of the carrying plate 200 may still damage the metal film deposited on the back surface of the wafer.

**In** order to solve the above technical problem, in an exemplary implementation of the present disclosure, as shown in FIG. 3 to FIG. 6, the insulating assembly includes an insulating plate 210, a middle insulating ring 220, and a top insulating ring 230, a bottom of the insulating plate 210 is connected to the lifting assembly, a bottom of the middle insulating ring 220 is disposed on the insulating plate 210, the radio frequency feed plate 240 is disposed above the middle insulating ring 220, the top insulating ring 230 is disposed around the radio frequency feed plate 240 and at a top of the middle insulating ring 220, the top insulating ring 230 is provided with the aforesaid supporting surface C for supporting the wafer 10, and the supporting surface C is higher than the top surface of the radio frequency feed plate 240, and is configured to support the wafer 10 carried on the plurality of support members 400 when the top ends of the plurality of support members 400 are lowered below the supporting surface C.

The insulating avoidance structures include a plurality of first avoidance notches 234 which are formed on an inner circumferential wall of the top insulating ring 230 and in one-to-one correspondence with the positions of the plurality of support members 400, and a plurality of second avoidance notches formed in the middle insulating ring 220, and a plurality of insulating sleeve members 250 are disposed in the plurality of second avoidance notches in a one-to-one correspondence manner.

**In** the embodiment of the present disclosure, the top insulating ring 230 surrounds the radio frequency feed plate 240, and the supporting surface C of the top insulating ring 230 is higher than the top surface of the radio frequency feed plate 240, so that the wafer can be supported by the supporting surface C of the top insulating ring 230 instead of the top ends of the support members 400 when the carrying plate is raised higher than the top ends of the support members 400, and the radio frequency feed plate 240 can be always prevented from being in direct contact with the bottom surface of the wafer, which ensures the integrity of the film on the back surface of the wafer 10 and improves the yield of the wafer products.

**In** addition, in the embodiment of the present disclosure, the insulating avoidance structures include the second avoidance notches formed at an edge of the middle insulating ring 220, so that the insulating sleeve members 250 are used instead of the middle insulating ring 220 to provide the inner walls of the first sleeve holes 251 to form gaps with the support members 400. When a semiconductor process is performed, the particles falling from above the carrying plate are attached to the inner walls of the first sleeve holes 251 of the insulating sleeve members 250. When cleaning is needed due to too many particles, only the insulating sleeve members 250 need to be detached and separately cleaned, and the structures such as the middle insulating ring 220 do not need to be detached from the carrying plate 200, so that the maintenance operations for the semiconductor process chamber are simplified.

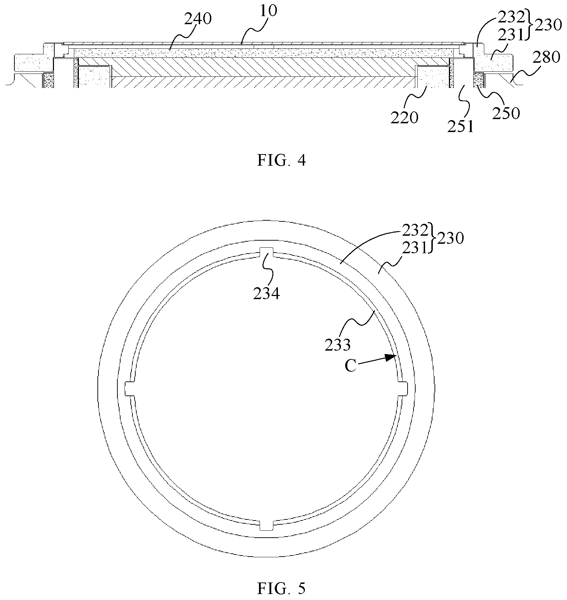

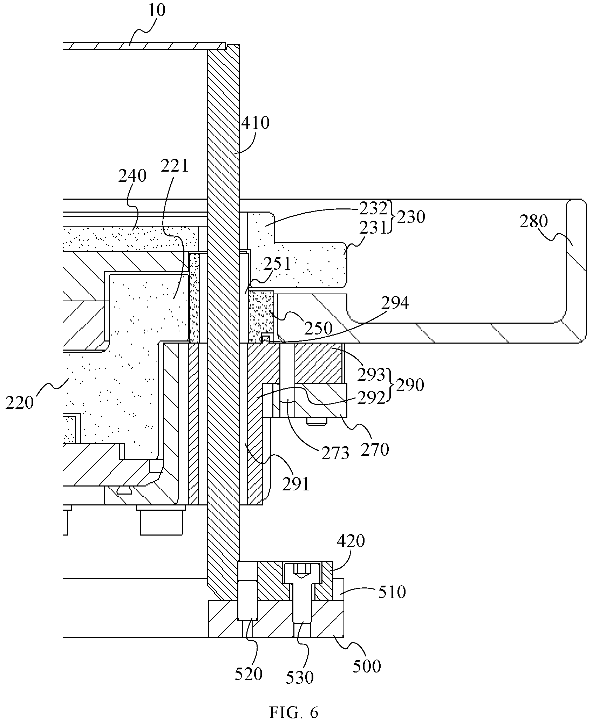

**In** an alternative implementation of the present disclosure, as shown in FIG. 5 and FIG. 6, an annular supporting groove 233 connected to an inner hole of the top insulating ring 230 is formed on a top surface of the top insulating ring 230, a bottom surface of the annular supporting groove 233 is formed into the supporting surface C, and a sidewall of the annular supporting groove 233 is configured to limit the wafer 10 placed on the supporting surface C.

**In** the embodiment of the present disclosure, the insulating plate 210, the middle insulating ring 220, the top insulating ring 230, and the plurality of insulating sleeve members 250 are all made of insulating materials such as ceramic materials. The radio frequency feed plate 240 is configured to be connected to a lower power supply through a cable inside the lifting shaft 310, so as to supply radio frequency signals to the wafer 10 above during a semiconductor process.

In an alternative implementation of the present disclosure, as shown in FIG. 4 to FIG. 6, the top insulating ring 230 includes an insulating-ring outward extension 231 and an insulating-ring main body 232, the insulating-ring outward extension 231 is disposed around an outer side of the insulating-ring main body 232, and a bottom surface of the insulating-ring outward extension 231 is flush with a bottom surface of the insulating-ring main body 232.

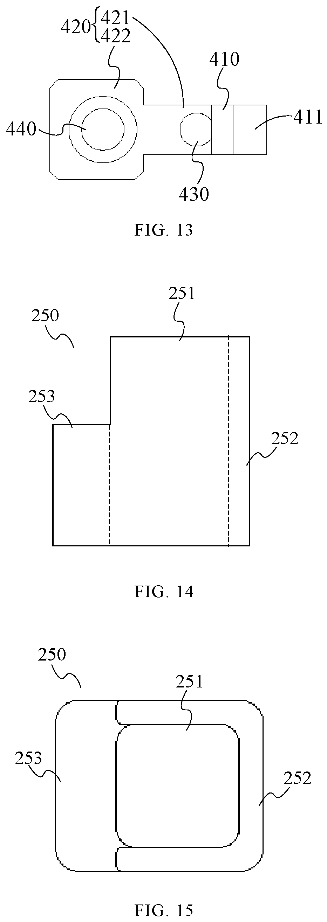

In an alternative implementation of the present disclosure, as shown in FIG. 3, FIG. 4, and FIG. 6, a first annular accommodating groove is formed at an edge of a top of the middle insulating ring 220, the middle insulating ring 220 supports the top insulating ring 230 through a bottom of the first annular accommodating groove, and a size of the second avoidance notch along a radial direction of the middle insulating ring 220 is greater than a size of the first annular accommodating groove along the radial direction of the middle insulating ring 220. As shown in FIG. 14 and FIG. 15, the insulating sleeve member 250 includes an insulating main body 252 and an insulating extension 253, a top of the insulating main body 252 is flush with the top of the middle insulating ring 220, and a top of the insulating extension 253 is flush with the bottom of the first annular accommodating groove.

In an exemplary implementation of the present disclosure, as shown in FIG. 3 and FIG. 6, the middle insulating ring 220 includes an insulating-ring main body and an outward extension 221 disposed around an outer side of a top end of the insulating-ring main body, and the second avoidance notches are formed in the outward extension 221.

The carrying plate 200 further includes a shielding assembly. As shown in FIG. 3, the chamber body 100 includes a loading chamber body 110 and a process chamber body 120 located at a top of the loading chamber body 110, a shielding cylinder 123 is disposed on an inner side of a sidewall of the process chamber body 120, and the lifting assembly is capable of driving the carrying plate 200 to raise to a position where the shielding assembly is in contact with a bottom end of the shielding cylinder 123, so as to isolate a process cavity inside the process chamber body 120 from a loading cavity inside the loading chamber body 110 with the shielding cylinder 123, the shielding assembly, and the carrying plate 200 and electrically connect the shielding cylinder 123 to the shielding assembly. Optionally, the bottom end of the shielding cylinder 123 extends to the loading chamber body 110, so as to be electrically connected to the shielding assembly.

In an alternative implementation of the present disclosure, the avoidance holes further include shielding avoidance structures formed in the shielding assembly, the matching sleeves 209 include conductive sleeve members 290 disposed in the shielding avoidance structures, the conductive sleeve members 290 support the insulating sleeve members 250 in a one-to-one correspondence manner, the conductive sleeve members 290 are provided with second sleeve holes 291, and the support members 400 are capable of passing through the second sleeve holes 291 along the vertical direction.

In the embodiment of the present disclosure, when the carrying plate 200 is raised to a position where the shielding assembly is in contact with the bottom end of the shielding cylinder 123, the shielding assembly can isolate the process cavity inside the process chamber body 120 from the loading cavity inside the loading chamber body 110 while isolating an electric field in the process cavity from an electric field below, so as to ensure a process effect of a semiconductor process performed inside the semiconductor process chamber.

Moreover, in the embodiment of the present disclosure, the shielding assembly is provided with the shielding avoidance structures corresponding to the positions of the support members 400, and the conductive sleeve members 290 are disposed in the shielding avoidance structures, so that the avoidance holes are partially formed in the conductive sleeve members 290, that is, the conductive sleeve members 290 are used instead of the shielding assembly to provide inner walls of the second sleeve holes 291 to form gaps with the support members 400. When a semiconductor process is performed, the particles falling from above the carrying plate are attached to the inner walls of the second sleeve holes 291 of the conductive sleeve members 290. When cleaning is needed due to too many particles, only the conductive sleeve members 290 need to be detached and separately cleaned, and the structures such as the shielding assembly do not need to be detached from the carrying plate 200, so that the maintenance operations for the carrying device and the semiconductor process chamber are simplified.

In an alternative implementation of the present disclosure, the shielding assembly includes a support connection plate 260, a ground shielding ring 270, and a top shielding member 280, the support connection plate 260 is disposed under a bottom of the insulating assembly (i.e., the insulating plate 210) and is grounded through the lifting assembly, the ground shielding ring 270 is disposed around an outer side of the insulating assembly (i.e., the insulating-ring main body), and the top shielding member 280 is disposed around the outer side of the insulating assembly (i.e., the outward extension 221 of the middle insulating ring 220) and on a top surface of the ground shielding ring 270 (that is, an edge of the top surface of the ground shielding ring protrudes from the outward extension 221 and supports a bottom of the ground shielding ring 270). As shown in FIG. 3, FIG. 7, and FIG. 8, the shielding avoidance structures are formed in the ground shielding ring 270.

The lifting assembly is capable of driving the carrying plate 200 to raise to a position where the top shielding member 280 is in contact with the bottom end of the shielding cylinder 123, so as to isolate the process cavity inside the process chamber body 120 from the loading cavity inside the loading chamber body 110 with the shielding cylinder 123, the top shielding member 280, and the carrying plate 200 and electrically connect the shielding cylinder 123 to the support connection plate 260 through the top shielding member 280.

In the embodiment of the present disclosure, the support connection plate 260, the ground shielding ring 270, the top shielding member 280, and the conductive sleeve members 290 are all conductors (such as being made of metal materials), the top shielding member 280 is electrically connected to the support connection plate 260 through the ground shielding ring 270 and the conductive sleeve members 290, and is further connected to a corresponding circuit inside the lifting shaft 310 through the support connection plate 260 to be grounded, so that when the carrying plate 200 is raised to the position where the top shielding member 280 is in contact with the bottom end of the shielding cylinder 123, the process cavity inside the process chamber body 120 is isolated from the loading cavity inside the loading chamber body 110, and meanwhile, the electric field in the process cavity is isolated from the electric field below, thereby ensuring a process effect of a semiconductor process performed inside the semiconductor process chamber.

Moreover, in the embodiment of the present disclosure, the ground shielding ring 270 is provided with the shielding avoidance structures corresponding to the positions of the support members 400, and the conductive sleeve members 290 are disposed in the shielding avoidance structures, so that the avoidance holes are partially formed in the conductive sleeve members 290, that is, the conductive sleeve members 290 are used instead of the ground shielding ring 270 to provide the inner walls of the second sleeve holes 291 to form the gaps with the support members 400. When a semiconductor process is performed, the particles falling from above the carrying plate are attached to the inner walls of the second sleeve holes 291 of the conductive sleeve members 290. When cleaning is needed due to too many particles, only the conductive sleeve members 290 need to be detached and separately cleaned, and the structures such as the ground shielding ring 270 do not need to be detached from the carrying plate 200, so that the maintenance operations for the carrying device and the semiconductor process chamber are simplified.

In an alternative implementation of the present disclosure, as shown in FIG. 3 and FIG. 9, the process chamber body 120 includes a support ring 121 and a ceramic ring 122, and a bottom end of the ceramic ring 122 is hermetically connected to a top opening of the loading chamber body 110 through the support ring 121. The shielding cylinder 123 is coaxial with the ceramic ring 122, and is disposed on an inner wall of the ceramic ring 122.

In order to increase the quantity of the contaminants and the particles adsorbed by the insulating sleeve members 250 and the conductive sleeve members 290, in an exemplary implementation of the present disclosure, hole walls of the first sleeve holes 251 and hole walls of the second sleeve holes 291 are surface-treated surfaces, roughness of the hole walls of the first sleeve holes 251 is greater than that of other surfaces of the insulating sleeve members 250, and roughness of the hole walls of the second sleeve holes 291 is greater than that of other surfaces of the conductive sleeve members 290.

In the embodiment of the present disclosure, the hole walls of the first sleeve holes 251 and the hole walls of the second sleeve holes 291 are subjected to surface treatment to increase the roughness of the hole walls of the first sleeve holes 251 and the roughness of the hole walls of the second sleeve holes 291, so that the quantity of the contaminants and the particles adsorbed by the insulating sleeve members 250 and the conductive sleeve members 290 can be increased, cleaning and maintenance frequency of the carrying plate can be reduced, and the machine production capacity can be further ensured.

In order to further ensure accuracy of alignment of columnar portions 410 and the avoidance holes, in an exemplary implementation of the present disclosure, as shown in FIG. 6 to FIG. 8, at least one positioning protrusion 294 is formed at a top of the conductive sleeve member 290, at least one positioning groove is formed at a bottom of the insulating sleeve member 250, and the positioning protrusions 294 are accommodated in the corresponding positioning grooves of the insulating sleeve members 250 in a one-to-one correspondence manner. Certainly, in practical applications, it may be the case that the at least one positioning protrusion 294 is formed at the bottom of the insulating sleeve member 250 and the at least one positioning groove is formed at the top of the conductive sleeve member 290.

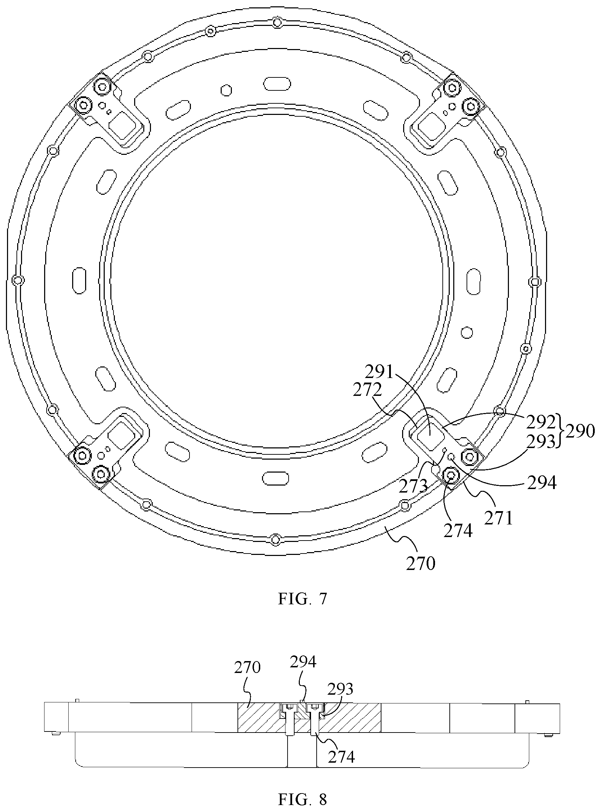

**In** an alternative implementation of the present disclosure, as shown in FIG. 6 and FIG. 7, the conductive sleeve members 290 include conductive main bodies 292 and conductive extensions 293, the second sleeve holes 291 are formed in the conductive main bodies 292, and the conductive extensions 293 are located on outer sides of the conductive main bodies 292 along a radial direction.

As shown in FIG. 7, the shielding avoidance structures include sleeve positioning grooves 271 formed on the top surface of the ground shielding ring 270, and sleeve positioning holes 272 penetrating from bottoms of the sleeve positioning grooves 271 to the bottom of the ground shielding ring 270, the sleeve positioning grooves 271 extend along a radial direction of the ground shielding ring 270 to be connected to an inner circumferential side of the ground shielding ring 270, the conductive main bodies 292 are disposed in the sleeve positioning holes 272, and the conductive extensions 293 are fixedly disposed in the sleeve positioning grooves 271.

Optionally, as shown in FIG. 3, the carrying plate 200 further includes a radio frequency connection plate 201, a lower cooling plate 202, and an upper cooling plate 203, which are located between the insulating plate 210 and the radio frequency feed plate 240 and are stacked in sequence from bottom to top, the radio frequency connection plate 201 is configured to transmit signals from a cable inside the lifting shaft 310 to the radio frequency feed plate 240, and the lower cooling plate 202 and the upper cooling plate 203 are configured to be connected to a cooling pipeline inside the lifting shaft 310, so as to cool the radio frequency feed plate 240 with a circulating cooling liquid.

**In** an alternative implementation of the present disclosure, the conductive sleeve members 290 may be fixedly connected to the ground shielding ring 270 with pins and threaded fasteners. Exemplarily, as shown in FIG. 6 to FIG. 8, the carrying device further includes a plurality of first positioning pins 273 and a plurality of first fixing screws 274, the bottoms of the sleeve positioning grooves 271 are provided with a plurality of first pin holes and a plurality of first threaded holes which penetrate to the bottom of the ground shielding ring 270, the conductive extensions 293 are provided with a plurality of first positioning holes and a plurality of first mounting holes which penetrate through the conductive extensions 293 along an axial direction of the carrying plate 200, the plurality of first positioning pins 273 pass through the plurality of first positioning holes and the corresponding first pin holes in a one-to-one correspondence manner, and the plurality of first fixing screws 274 pass through the plurality of first mounting holes and the corresponding first threaded holes in a one-to-one correspondence manner, so as to fixedly connect the ground shielding ring 270 to a plurality of conductive extensions 293.

In an alternative implementation of the present disclosure, as shown in FIG. 3 and FIG. 6, the carrying device further includes a connecting ring 500, which is disposed around an axis of the carrying plate 200 and is fixedly connected to the chamber body 100; and as shown in FIG. 3, FIG. 6, and FIG. 12, the support members 400 include the columnar portions 410 and connecting portions 420, the connecting portions 420 are fixedly connected to the connecting ring 500, the columnar portions 410 extend along the vertical direction, top ends of the columnar portions 410 are configured to pass through the corresponding avoidance holes and support the wafer, the connecting portions 420 extend along a radial direction of the carrying plate 200, and ends of connecting portions 420 facing the axis of the carrying plate 200 are fixedly connected to bottom ends of the columnar portions 410.

FIG. 1(a) and FIG. 1(b) are schematic structural diagrams of a semiconductor process chamber in an existing art. As shown in FIG. 1(a) and FIG. 1(b), a reaction chamber structure includes a chamber body 100, a carrying plate 200 disposed in the chamber body 100, and a wafer support assembly 20, the wafer support assembly 20 includes a connecting ring 21 and three support rods 22 (i.e., pins) that are fixedly disposed on the connecting ring 21 and are uniformly distributed along a circumferential direction, the connecting ring 21 is fixedly connected to a bottom surface of the chamber body 100, and the carrying plate 200 may move up and down in the chamber body 100.

FIG. 2 is a schematic structural diagram of the wafer support assembly 20, and a top end of each support rod 22 is provided with a supporting and limiting portion 23, which has a limiting surface A and a supporting surface B. In a case where a metal film is already deposited on the back surface of the wafer 10 except for the edge region of the wafer 10, the supporting surface B of the support rod 22 provides support for the edge of the wafer 10 without damaging the deposited metal film on the back surface of the wafer. The limiting surface A is an inclined surface, and can play a role in guiding and limiting the wafer, thereby ensuring stability of a horizontal position of the wafer.

It has also been found in the research that a main reason why the carrying plate is often contaminated too fast when adopting the existing semiconductor process chamber for a semiconductor process is as follows: an avoidance hole formed on the carrying plate 200 and matched with each support rod 22 needs to be designed to allow the support rod 22 and the supporting and limiting portion 23 at the top end thereof to freely pass through, such that a relatively large gap needs to be kept between an inner wall of the avoidance hole and the support rod 22; but when the wafer 10 is placed on the support rod 22, as shown in FIG. 1(a), the gap cannot be completely covered, such that particles in the chamber body 100 can easily fall into the gap and be adsorbed to a hole wall of the avoidance hole and surfaces of components of the carrying plate, resulting in the contamination of the carrying plate. When the particles accumulate to a certain extent, the components of the carrying plate which adsorb the particles need to be replaced and cleaned as a whole, which shortens a maintenance period, affects production efficiency, and causes inconvenience to use and maintenance of the semiconductor process chamber.

In order to solve the above technical problem, in an exemplary implementation of the present disclosure, as shown in FIG. 3 and FIG. 6, a cross-sectional area of the columnar portion 410 at a height is not larger than that of the columnar portion 410 at a height below the height.

In the embodiment of the present disclosure, the cross-sectional area of the columnar portion 410 at a height is not larger than that of the columnar portion 410 at a height below the height, so that a cross section of a part of the columnar portion 410 located in the avoidance hole is not less than that of a part of the columnar portion 410 above the carrying plate 200 after the top end of the columnar portion 410 is moved upwards and passes through the avoidance hole, and the columnar portion 410 can always maintain an effect of filling up the inner space of the avoidance hole in a case where both a shape and a size of the avoidance hole correspond to the maximum cross section of the columnar portion 410. That is, a gap between the columnar portion 410 and the inner wall of the avoidance hole is not enlarged after the top end of the columnar portion 410 passes out to be above the carrying plate 200, so that the number of particles entering the gap between the columnar portion 410 and the inner wall of the avoidance hole can be reduced, which ensures surface cleanliness of structures such as the carrying plate 200, prolongs the maintenance period of the semiconductor process chamber, and ensures machine production efficiency.

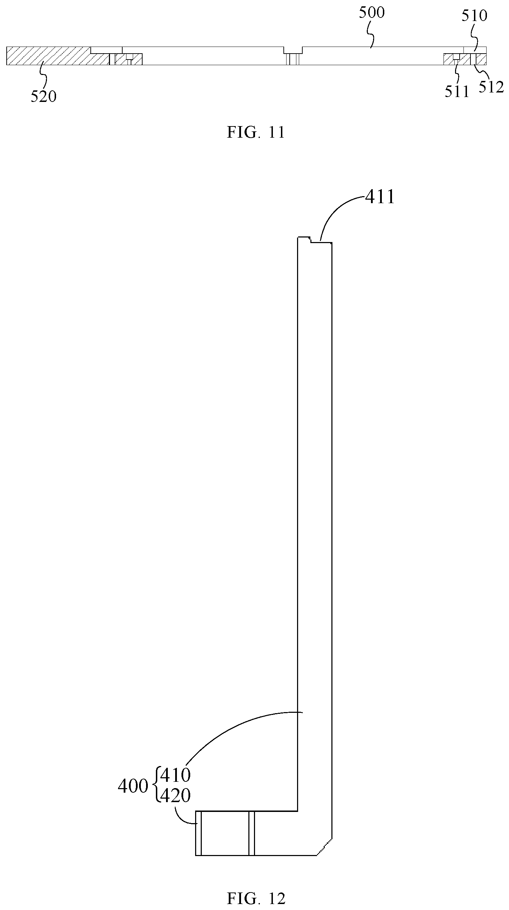

In an alternative implementation of the present disclosure, as shown in FIG. 12 and FIG. 13, an accommodating groove 411 is formed on an end surface of the top end of the columnar portion 410, one side of the accommodating groove 411 facing the axis of the carrying plate 200 extends to a side surface of the columnar portion 410, a bottom surface of the accommodating groove 411 is configured to support the wafer 10, and a sidewall of the accommodating groove 411 is configured to limit the edge of the wafer 10.

In order to ensure surface cleanliness of structural components such as the carrying plate 200, in an exemplary implementation of the present disclosure, as shown in FIG. 9 and FIG. 13, a horizontal projection shape of the columnar portion 410 is a square, and horizontal projection shapes of inner holes (i.e., the first sleeve hole 251 and the second sleeve hole 291) of the matching sleeve 209 correspond to the horizontal projection shape of the columnar portion 410.

In the embodiment of the present disclosure, the horizontal projection shapes of the columnar portion 410 and the inner holes of the matching sleeve 209 are all squares, so that a particle adsorption effect of the matching sleeve 209 can be improved with edge structures on the hole walls of the inner holes of the matching sleeve 209, so as to reduce the number of particles attached to surfaces of other components, and further ensure the surface cleanliness of the structural components such as the carrying plate 200.

In an alternative implementation of the present disclosure, the connecting portions 420 of the support members 400 may be fixedly connected to the connecting ring 500 with pins and threaded fasteners. Exemplarily, as shown in FIG. 6 and FIG. 13, the carrying device further includes a plurality of second positioning pins 520 and a plurality of second fixing screws 530, a plurality of supporting positioning grooves 510 are formed at a top of the connecting ring 500, the carrying device further include the plurality of second positioning pins 520 and the plurality of second fixing screws 530, the connecting portions 420 are disposed in the supporting positioning grooves 510 in a one-to-one correspondence manner, bottoms of the supporting positioning grooves 510 are provided with second pin holes 511 and second threaded holes 512 which penetrate to a bottom of the connecting ring 500, the connecting portions 420 are provided with second positioning holes 430 and second mounting holes 440 which penetrate through the connecting portions 420 along the axial direction of the carrying plate 200, the plurality of second positioning pins 520 pass through a plurality of second positioning holes 430 and the corresponding second pin holes 511 in a one-to-one correspondence manner, and the plurality of second fixing screws 530 pass through a plurality of second mounting holes 440 and the corresponding second threaded holes 512 in a one-to-one correspondence manner, so as to fixedly connect the connecting ring 500 to a plurality of connecting portions 420.

In the embodiment of the present disclosure, horizontal positions of the connecting portions 420 of the support members 400 are limited by the second positioning pins 520 together with the supporting positioning grooves 510 of the connecting ring 500, and the connecting portions 420 are fastened to the connecting ring 500 through the second threaded holes 512, so that accuracy of relative positions of the columnar portions 410 of the support members 400 and the connecting ring 500 can be ensured, which further ensures the accuracy of the alignment of the columnar portions 410 and the avoidance holes.

Exemplarily, as shown in FIG. 10, the supporting positioning grooves 510 extend along a radial direction of the connecting ring 500, and one second pin hole 511 and one second threaded hole 512 are formed in each supporting positioning groove 510.

In the embodiment of the present disclosure, the supporting positioning grooves 510 extend along the radial direction of the connecting ring 500, and each support member 400 is aligned with the connecting ring 500 only by one second positioning pin 520, so that the horizontal positions of the connecting portions 420 are limited by sidewalls of the supporting positioning grooves 510 together with the second positioning pins 520, which ensures the accuracy of the alignment of the columnar portions 410 and the avoidance holes while simplifying the structure of the device.

In an alternative implementation of the present disclosure, as shown in FIG. 13, the connecting portion 420 includes an extending portion 421 and a limiting portion 422 connected to each other, the extending portion 421 and the limiting portion 422 are distributed along the radial direction of the connecting ring 500, the extending portion 421 is connected between the limiting portion 422 and the bottom end of the columnar portion 410, a size of the limiting portion 422 along a direction perpendicular to the radial direction of the connecting ring 500 is larger than that of the extending portion 421 along the direction perpendicular to the radial direction of the connecting ring 500, and the sidewall of the supporting positioning groove 510 is configured to limit a sidewall of the extending portion 421, so as to limit a circumferential position of the support member 400.

In an exemplary implementation of the present disclosure, as shown in FIG. 6 and FIG. 10, an inner wall of the connecting ring 500 is provided with a plurality of protrusions 550 which extend in a direction toward an axis of the connecting ring 500 and are in one-to-one correspondence with circumferential positions of the plurality of supporting positioning grooves 510, and the supporting positioning grooves 510 extend to the protrusions 550. That is, the connecting ring 500 is only widened at the positions where the support members 400 are disposed, and a cross section of the connecting ring 500 is narrowed at the other positions, so that an overall weight of the connecting ring 500 is reduced, and verticality of a plurality of columnar portions 410 is ensured, which further ensures the accuracy of the alignment of the columnar portions 410 and the avoidance holes.

In an alternative implementation of the present disclosure, as shown in FIG. 3, the carrying device further includes a supporting adapter 600, and the bottom of the connecting ring 500 is fixedly connected to the bottom wall of the chamber body 100 through the supporting adapter 600, so as to be spaced from the bottom wall of the chamber body 100 along the vertical direction.

In an alternative implementation of the present disclosure, as shown in FIG. 3, the supporting adapter 600 includes an upper flange, a lower flange, and a connecting column connected between the upper flange and the lower flange. As shown in FIG. 10, the connecting ring 500 is provided with a connecting portion 540, which is fastened to the upper flange of the supporting adapter 600 with a fastener (e.g., a bolt), and the lower flange of the supporting adapter 600 is fastened to the bottom wall of the chamber body 100 with a fastener (e.g., a bolt).

In a second aspect of the present disclosure, a semiconductor process chamber is provided. As shown in FIG. 3, the semiconductor process chamber includes a chamber body 100 and the above carrying device provided in the embodiment of the present disclosure.

In the semiconductor process chamber provided in the present disclosure, the matching sleeves 209 are disposed in the avoidance holes of the carrying plate 200, and the support members 400 pass through the matching sleeves 209 to extend out of the avoidance holes or retract into the avoidance holes, so that the particles falling from above the carrying plate 200 can be attached to the matching sleeves 209 after entering the avoidance holes when a semiconductor process is performed. When the particles attached to the avoidance holes are too many and cleaning is needed for restoring the cleanliness of the carrying plate 200, instead of detaching all parts of the carrying plate 200 one by one, only the matching sleeves 209 need to be detached and separately cleaned, which simplifies an maintenance operation for the semiconductor process chamber, and shortens the time spent on disassembling and assembling the carrying plate 200 in the maintenance operation, thereby improving the maintenance efficiency of the carrying plate and ensuring the machine production capacity.

In an alternative implementation of the present disclosure, as shown in FIG. 3, the lifting assembly may include the drive component and the lifting shaft 310, the avoidance through hole is formed in the bottom wall of the chamber body 100, the bottom end of the lifting shaft 310 is connected to the drive component, and the top end of the lifting shaft 310 passes through the avoidance through hole to enter the chamber body 100, and is fixedly connected to the bottom of the carrying plate 200.

In order to ensure airtightness of the semiconductor process chamber, exemplarily, as shown in FIG. 3, the lifting assembly further includes the corrugated tube 321 sleeved over the lifting shaft 310, the top end of the corrugated tube 321 is hermetically connected to the bottom of the carrying plate 200, and the bottom end of the corrugated tube 321 is hermetically connected to the avoidance through hole, so as to isolate an interior of the chamber body 100 from the external space. Optionally, as shown in FIG. 3, the lifting assembly further includes the bottom flange 322 fixedly disposed at the bottom of the carrying plate 200 and configured to hermetically connect the bottom end of the corrugated tube 321 to the avoidance through hole.

In an exemplary implementation of the present disclosure, as shown in FIG. 3, the carrying plate 200 further includes a shielding assembly, the chamber body 100 includes a loading chamber body 110 and a process chamber body 120 located at a top of the loading chamber body 110, a shielding cylinder 123 is disposed on an inner side of a sidewall of the process chamber body 120, and the lifting assembly is capable of driving the carrying plate 200 to raise to a position where the shielding assembly is in contact with a bottom end of the shielding cylinder 123, so as to isolate a process cavity inside the process chamber body 120 from a loading cavity inside the loading chamber body 110 with the shielding cylinder 123 and the carrying plate 200 and electrically connect the shielding cylinder 123 to the shielding assembly. Optionally, the bottom end of the shielding cylinder 123 extends to the loading chamber body 110, so as to be electrically connected to the shielding assembly.

In an alternative implementation of the present disclosure, the avoidance hole further includes a shielding avoidance structure formed in the shielding assembly, the matching sleeve 209 includes a conductive sleeve member 290 disposed in the shielding avoidance structure, the conductive sleeve members 290 support the insulating sleeve members 250 in a one-to-one correspondence manner, and the conductive sleeve member 290 is provided with the second sleeve hole 291, and the support member 400 may pass through the second sleeve hole 291 along the vertical direction.

In an alternative implementation of the present disclosure, as shown in FIG. 3 and FIG. 9, the process chamber body 120 includes a support ring 121 and a ceramic ring 122, and a bottom end of the ceramic ring 122 is hermetically connected to a top opening of the loading chamber body 110 through the support ring 121. The shielding cylinder 123 is coaxial with the ceramic ring 122, and is disposed on an inner wall of the ceramic ring 122.

It should be understood that the above implementations are merely exemplary implementations adopted to illustrate the principle of the present disclosure, and the present disclosure is not limited thereto. Various modifications and improvements can be made by those of ordinary sill in the art without departing from the spirit and essence of the present disclosure, and those modifications and improvements are also considered to fall within the scope of the present disclosure.

## Claims

1. A carrying device for being disposed in a chamber body of a semiconductor process chamber, comprising a carrying plate and a plurality of support members, wherein the carrying plate is provided with a plurality of avoidance holes which are in one-to-one correspondence with positions of the plurality of support members and penetrate through the carrying plate along a height direction, the carrying plate is capable of moving up and down relative to the support members, so as to enable top ends of the support members to pass out through the avoidance holes to be above the carrying plate and hold a wafer up from the carrying plate or to enable the top ends of the support members to retract into the avoidance holes and place the wafer on the carrying plate, the carrying device further comprises a plurality of matching sleeves, which are disposed in the plurality of avoidance holes in a one-to-one correspondence manner, outer surfaces of the matching sleeves are attached to outer walls of the avoidance holes, and the support members are capable of passing through the matching sleeves at corresponding positions.

2. The carrying device of claim 1, further comprising a lifting assembly, which is configured to drive the carrying plate to move up and down, wherein the carrying plate comprises a radio frequency feed plate and an insulating assembly, the insulating assembly is connected between the lifting assembly and the radio frequency feed plate, and has a supporting surface for supporting the wafer, and the supporting surface is higher than a top surface of the radio frequency feed plate, and is configured to support the wafer carried on the support members when the top ends of the plurality of support members are lowered below the supporting surface.

3. The carrying device of claim 2, wherein the avoidance holes comprise insulating avoidance structures formed in the insulating assembly, the matching sleeves comprise insulating sleeve members disposed in the insulating avoidance structures, the insulating sleeve members are provided with first sleeve holes, and the support members are capable of passing through the first sleeve holes along a vertical direction.

4. The carrying device of claim 3, wherein the insulating assembly comprises an insulating plate, a middle insulating ring, and a top insulating ring, a bottom of the insulating plate is connected to the lifting assembly, a bottom of the middle insulating ring is disposed on the insulating plate, the radio frequency feed plate is disposed above the middle insulating ring, the top insulating ring is disposed around the radio frequency feed plate and at a top of the middle insulating ring, and the top insulating ring is provided with the supporting surface; and
the insulating avoidance structures comprise a plurality of first avoidance notches which are formed on an inner circumferential wall of the top insulating ring and in one-to-one correspondence with the positions of the plurality of support members, and a plurality of second avoidance notches formed in the middle insulating ring, and a plurality of insulating sleeve members are disposed in the plurality of second avoidance notches in a one-to-one correspondence manner.

5. The carrying device of claim 3, wherein the carrying plate further comprises a shielding assembly, and
the chamber body comprises a loading chamber body and a process chamber body located at a top of the loading chamber body and communicated with the loading chamber body, a shielding cylinder is disposed on an inner side of a sidewall of the process chamber body, and the lifting assembly is capable of driving the carrying plate to raise to a position where the shielding assembly is in contact with a bottom end of the shielding cylinder, so as to isolate a process cavity inside the process chamber body from a loading cavity inside the loading chamber body with the shielding cylinder, the shielding assembly, and the carrying plate and electrically connect the shielding cylinder to the shielding assembly.

6. The carrying device of claim 5, wherein the avoidance holes further comprise shielding avoidance structures formed in the shielding assembly, the matching sleeves further comprise conductive sleeve members disposed in the shielding avoidance structures, the conductive sleeve members support the insulating sleeve members in a one-to-one correspondence manner, the conductive sleeve members are provided with second sleeve holes, and the support members are capable of passing through the second sleeve holes along the vertical direction.

7. The carrying device of claim 6, wherein hole walls of the first sleeve holes and hole walls of the second sleeve holes are surface-treated surfaces, roughness of the hole walls of the first sleeve holes is greater than roughness of other surfaces of the insulating sleeve members, and roughness of the hole walls of the second sleeve holes is greater than roughness of other surfaces of the conductive sleeve members.

8. The carrying device of claim 6, wherein one of a top of each conductive sleeve member and a bottom of each insulating sleeve member is provided with at least one positioning protrusion, the other of the top of each conductive sleeve member and the bottom of each insulating sleeve member is provided with at least one positioning groove, and positioning protrusions are accommodated in corresponding positioning grooves in a one-to-one correspondence manner.

9. The carrying device of claim 6, wherein the shielding assembly comprises a support connection plate, a ground shielding ring, and a top shielding member, the support connection plate is disposed under a bottom of the insulating assembly and is grounded through the lifting assembly, the ground shielding ring is disposed around an outer side of the insulating assembly, and the top shielding member is disposed around the outer side of the insulating assembly and on a top surface of the ground shielding ring; the shielding avoidance structures are formed in the ground shielding ring; and
the lifting assembly is capable of driving the carrying plate to raise to a position where the top shielding member is in contact with the bottom end of the shielding cylinder, so as to isolate the process cavity inside the process chamber body from the loading cavity inside the loading chamber body with the shielding cylinder, the top shielding member, and the carrying plate and electrically connect the shielding cylinder to the support connection plate through the top shielding member.

10. The carrying device of claim 9, wherein the conductive sleeve members comprise conductive main bodies and conductive extensions, the second sleeve holes are formed in the conductive main bodies, and the conductive extensions are located on outer sides of the conductive main bodies along a radial direction; and
the shielding avoidance structures comprise sleeve positioning grooves formed on the top surface of the ground shielding ring, and sleeve positioning holes penetrating from bottoms of the sleeve positioning grooves to a bottom of the ground shielding ring, the sleeve positioning grooves extend along a radial direction of the ground shielding ring to be connected to an inner circumferential side of the ground shielding ring, the conductive main bodies are disposed in the sleeve positioning holes, and the conductive extensions are fixedly disposed in the sleeve positioning grooves.

11. The carrying device of claim 10, further comprising a plurality of first positioning pins and a plurality of first fixing screws, the bottoms of the sleeve positioning grooves are provided with a plurality of first pin holes and a plurality of first threaded holes which penetrate to the bottom of the ground shielding ring, the conductive extensions are provided with a plurality of first positioning holes and a plurality of first mounting holes which penetrate through the conductive extensions along an axial direction of the carrying plate, the plurality of first positioning pins pass through the plurality of first positioning holes and the corresponding first pin holes in a one-to-one correspondence manner, and the plurality of first fixing screws pass through the plurality of first mounting holes and the corresponding first threaded holes in a one-to-one correspondence manner, so as to fixedly connect the ground shielding ring to a plurality of conductive extensions.

12. The carrying device of claim 4, wherein an annular supporting groove connected to an inner hole of the top insulating ring is formed on a top surface of the top insulating ring, a bottom surface of the annular supporting groove is formed into the supporting surface, and a sidewall of the annular supporting groove is configured to limit the wafer placed on the supporting surface.

13. The carrying device of any one of claims 1 to 12, further comprising a connecting ring, which is disposed around an axis of the carrying plate and is configured to be fixedly connected to the chamber body; and
the support members comprise columnar portions and connecting portions, the connecting portions are fixedly connected to the connecting ring, the columnar portions extend along a vertical direction, top ends of the columnar portions are configured to pass through the corresponding avoidance holes and support the wafer, and the connecting portions are fixedly connected to bottom ends of the columnar portions.

14. The carrying device of claim 13, wherein an accommodating groove is formed on an end surface of a top end of each columnar portion, one side of the accommodating groove facing the axis of the carrying plate extends to a side surface of the columnar portion, a bottom surface of the accommodating groove is configured to support the wafer, and a sidewall of the accommodating groove is configured to limit an edge of the wafer.

15. The carrying device of claim 13, wherein shapes of orthographic projections of the columnar portions on a horizontal plane are squares, and shapes of orthographic projections of inner holes of the matching sleeves correspond to the shapes of the orthographic projections of the columnar portions on the horizontal plane.

16. The carrying device of claim 13, further comprising a plurality of second positioning pins and a plurality of second fixing screws, wherein
a plurality of supporting positioning grooves are formed at a top of the connecting ring, the connecting portions are disposed in the supporting positioning grooves in a one-to-one correspondence manner, bottoms of the supporting positioning grooves are provided with second pin holes and second threaded holes which penetrate to a bottom of the connecting ring, the connecting portions are provided with second positioning holes and second mounting holes which penetrate through the connecting portions along an axial direction of the carrying plate, the plurality of second positioning pins pass through a plurality of second positioning holes and the corresponding second pin holes in a one-to-one correspondence manner, and the plurality of second fixing screws pass through a plurality of second mounting holes and the corresponding second threaded holes in a one-to-one correspondence manner, so as to fixedly connect the connecting ring to a plurality of connecting portions.

17. A semiconductor process chamber, comprising a chamber body and the carrying device of any one of claims 1 to 16.
